# FASCICULE DE BREVET EUROPEEN

(11) **EP 4 393 025 B1**
(45) Date de publication et mention de la délivrance du brevet: **14.05.2025**
(21) Numéro de dépôt: 23749130.3
(22) Date de dépôt: 18.07.2023
(51) Int. Cl.: H01M 10/42, G01R 31/385, H01M 10/48, H01M 10/04, G01R 31/3842

(54) **APPAREIL ET PROCÉDÉ D'INSPECTION D'UNE CELLULE SECONDAIRE**
VORRICHTUNG UND VERFAHREN ZUR INSPEKTION EINER SEKUNDÄRZELLE
APPARATUS AND METHOD FOR INSPECTING A SECONDARY CELL

(30) Priorité: 19.07.2022 FR 2207369
(43) Date de publication de la demande: 03.07.2024
(73) Titulaire: Verkor, 38000 Grenoble (FR)
(72) Inventeur: VIDAL, Delphine, 38000 GRENOBLE (FR); HEILMAN, Drew, 38000 GRENOBLE (FR); KIM, Jeong Hyun, 38000 GRENOBLE (FR)
(74) Mandataire: Novagraaf Group
(86) Numéro de dépôt international: PCT/FR2023/051109
(87) Numéro de publication internationale: WO 2024/018150

(56) Documents cités:
- EP-A1- 2 833 434
- EP-A1- 3 428 670
- EP-A1- 3 683 589
- DE-A1- 102020 005 411

## Description

### Domaine technique de l'invention

La présente invention concerne le domaine de la détection des défauts dans une cellule secondaire, en particulier la présente invention concerne un appareil et un procédé d'inspection pour inspecter au moins une cellule secondaire.

### Arrière-plan technique

Lors de la fabrication des cellules secondaires, à savoir des batteries électriques qui peuvent être chargées, déchargées dans une charge électrique, et rechargées de nombreuses fois, et en particulier des sachets souples de cellules secondaires, la contamination de la cellule secondaire est un problème fréquemment rencontré. Cette contamination peut être causée, par exemple, par une particule métallique ou une bavure qui reste à la surface d'une électrode à l'intérieur de la cellule secondaire.

En effet, dans les cellules des batteries lithium-ion, la présence indésirable d'une contamination entre deux électrodes peut provoquer un court-circuit interne à l'intérieur de la batterie lithium-ion, entraînant une défaillance, des dommages et, dans les cas graves, l'inflammation de la batterie.

Cette contamination est particulièrement difficile à détecter dans les cellules secondaires. De nombreuses tentatives ont été faites pour résoudre ce problème. Par exemple, le document EP3415938 A1 décrit une technique pour détecter un défaut de basse tension qui peut se produire dans une cellule secondaire, comprenant une étape d'assemblage d'une cellule secondaire, une étape de vieillissement de la cellule secondaire assemblée, une étape de charge de la cellule secondaire vieillie, et une étape de détection d'un défaut de la secondaire. Si la cellule secondaire présente une chute de tension supérieure à son taux d'autodécharge normal, on considère qu'un défaut de basse tension se produit dans la cellule secondaire.

Cependant, la technique décrite dans le document EP3415938 A1 nécessite un temps considérable du fait des longues étapes de vieillissement impliquées. En outre, la technique décrite ne tient pas compte de l'influence de la variation de température sur les paramètres mesurés.

Un objet de la présente invention est d'inspecter avec précision, facilité et rapidité si un contaminant est présent à l'intérieur d'une cellule secondaire.

### Résumé de l'invention

À cet effet, l'invention concerne un appareil d'inspection pour inspecter au moins une cellule secondaire, l'appareil d'inspection comprenant :
- un élément de support fixe ;
- un élément mobile installé pour faire face à l'élément de support et étant mobile par rapport à l'élément de support le long d'un axe principal dans une première direction vers l'élément de support et une seconde direction opposée à la première direction, chaque direction étant le long de l'axe principal ;
- des éléments de pression installés entre l'élément de support et l'élément mobile, lesdits éléments de pression étant librement mobiles le long de l'axe principal, deux éléments de pression adjacents définissant un espace destiné à recevoir une cellule secondaire ;
   et
- une unité d'entraînement configurée pour fonctionner dans un premier état dans lequel l'unité d'entraînement presse l'au moins une cellule secondaire qui se trouve entre deux éléments de pression, et un second état dans lequel l'unité d'entraînement libère l'au moins une cellule secondaire,
- une unité de mesure de pression configurée pour mesurer la pression appliquée par l'unité d'entraînement ;
- une unité de contrôle de courant configurée pour appliquer une tension sur l'au moins une cellule secondaire et pour mesurer un courant correspondant à travers l'au moins une cellule secondaire ;
dans lequel :
chaque élément de pression parmi les éléments de pression comprend une plaque thermique comprenant une platine métallique comprenant un réseau d'éléments thermo régulateurs, la plaque thermique étant apte à maintenir une température constante entre les éléments de pression dans une plage de température comprise entre 5°C et 120°C.

Selon un mode de réalisation, l'appareil d'inspection comprend en outre un élément de guidage configuré pour guider chaque élément de pression pour qu'il se déplace le long de l'axe principal librement dans la première direction et dans la deuxième direction de manière à ajuster un espace séparant deux éléments de pression adjacents.

Selon une caractéristique, les plaques thermiques sont couplées à un régulateur de température qui contrôle une valeur de la température entre deux éléments de pression adjacents.

Selon un mode de réalisation, l'appareil d'inspection comprend en outre une unité de contrôle de courant comprenant :
- une source d'énergie pour appliquer une tension pour atteindre une valeur de tension prédéterminée par rapport à l'au moins une cellule secondaire mise sous pression par l'élément de pression ; et
- une unité de mesure de courant pour mesurer une valeur de courant circulant à travers l'au moins une cellule secondaire.

Selon un mode de réalisation, l'appareil d'inspection comprend en outre un module d'électrode connecté à chacune des bornes d'électrode de l'au moins une cellule secondaire pour ainsi appliquer ou recevoir du courant.

Selon un mode de réalisation, l'appareil d'inspection comprend en outre un contrôleur qui est connecté à l'unité d'entraînement de pression, au module d'électrode et à l'unité de contrôle de courant, respectivement, pour commander les opérations de mise sous pression et de relâchement de l'unité d'entraînement, et pour déterminer s'il y a ou non un défaut dans l'au moins une cellule secondaire en comparant la valeur de courant mesurée par l'unité de contrôle de courant et une valeur de courant de référence.

Selon un mode de réalisation, l'appareil d'inspection comprend un cadre destiné à être installé sur un support, l'élément de support étant installé de manière à être perpendiculaire au cadre,
le cadre comprenant un châssis reposant sur le sol et une paire de cadres de support prévus de part et d'autre du châssis pour se faire face,
et dans lequel :
   l'unité de mesure de pression comprend un capteur de pressione interposé entre un élément fixe fixé pour faire face à l'élément de support et le cadre de support prévu sur un côté du châssis,
   le capteur de pression étant configuré pour mesurer une pression lorsque les éléments de pression mettent sous pression l'au moins une cellule secondaire lorsque l'unité d'entraînement est dans son premier état de fonctionnement.

Selon un mode de réalisation, l'unité de mesure de pression comprend un capteur de pression compris entre deux éléments de pression adjacents parmi les éléments de pression.

Selon une caractéristique, l'espace est destiné à recevoir une seule cellule secondaire.

Selon un mode de réalisation, l'élément mobile est mobile en translation selon la première direction et la deuxième direction, entre une première position correspondant au premier état et une deuxième position correspondant au deuxième état.

L'invention concerne en outre un procédé d'inspection pour inspecter au moins une cellule secondaire, le procédé d'inspection comprenant les étapes suivantes :
- fournir l'appareil d'inspection tel que décrit précédemment ;
- fournir l'au moins une cellule secondaire à inspecter ;
- introduire l'au moins une cellule secondaire dans l'appareil d'inspection de sorte que l'au moins une cellule secondaire soit introduite entre deux éléments de pression adjacents ;
- mettre sous pression et libérer l'au moins une cellule secondaire entre les éléments de pression des deux côtés en déplaçant l'élément mobile par rapport à l'élément de support le long d'un axe principal dans une première direction et une seconde direction opposées l'une à l'autre ;
- maintenir une température constante entre les éléments de pression en utilisant les plaques thermiques comprises dans les éléments de pression ;
- mesurer la pression appliquée à l'au moins une cellule secondaire en utilisant l'unité de mesure de pression afin de déterminer si la pression appliquée est dans une plage de pression prédéfinie ;
- appliquer une tension à l'au moins une cellule secondaire et mesurer un courant correspondant à travers l'au moins une cellule secondaire.

Selon une caractéristique du procédé d'inspection, le procédé d'inspection comprend en outre les étapes suivantes :
- comparer la valeur de courant mesurée à une valeur de courant de référence ;
- trier l'au moins une cellule secondaire comme étant fonctionnelle ou défectueuse sur la base de la comparaison entre la valeur de courant mesurée et la valeur de courant de référence de telle sorte que :
   si la valeur de courant mesurée dépasse la valeur de courant de référence, l'au moins une cellule secondaire est considérée comme défectueuse,
   si la valeur de courant mesurée est inférieure à la valeur de courant de référence, l'au moins une cellule secondaire est considérée comme fonctionnelle.

Selon un mode de réalisation, l'étape consistant à fournir l'au moins une cellule secondaire comprend les sous-étapes suivantes :
- assembler une première électrode et une seconde électrode et un séparateur interposé entre la première électrode et la seconde électrode afin de créer un bobinot ou un empilement ;
- placer le bobinot ou l'empilement dans un boîtier ou un sachet souple ;
- remplir le boîtier ou le sachet d'un électrolyte ;
- fermer hermétiquement le boîtier ou le sachet afin d'obtenir l'au moins une cellule secondaire ;
- charger l'au moins une cellule secondaire à un état de charge prédéterminé afin de former une interphase d'électrolyte solide sur la surface de la première électrode avant de placer l'au moins une cellule secondaire dans l'appareil d'inspection.

D'autres avantages et caractéristiques apparaîtront dans la description détaillée qui suit.

### Brève description des figures

L'invention va maintenant être décrite, à titre d'exemple seulement, en référence aux figures ci-jointes, dans lesquelles :
[Fig.1] la figure 1 est une vue en perspective, une vue de dessus et une vue de côté d'un appareil d'inspection selon l'invention.
[Fig.2] la figure 2 est une vue en coupe de l'appareil d'inspection selon la Figure 1.
[Fig.3] la figure 3 est une vue éclatée montrant l'intérieur d'un élément de pression compris dans l'appareil d'inspection et configuré pour mettre sous pression au moins une cellule secondaire.
[Fig.4] la figure 4 est une vue schématique de l'intérieur d'au moins une cellule secondaire qui est mise sous pression à l'intérieur de l'appareil d'inspection.

Dans ces figures, les mêmes chiffres de référence sont utilisés pour désigner les mêmes éléments.

Pour des raisons de clarté, les figures ne sont pas nécessairement reproduites à l'échelle.

### Description détaillée

L'invention concerne un appareil d'inspection 1 pour l'inspection d'au moins une cellule secondaire 110 qui peut être une cellule en sachet par exemple.

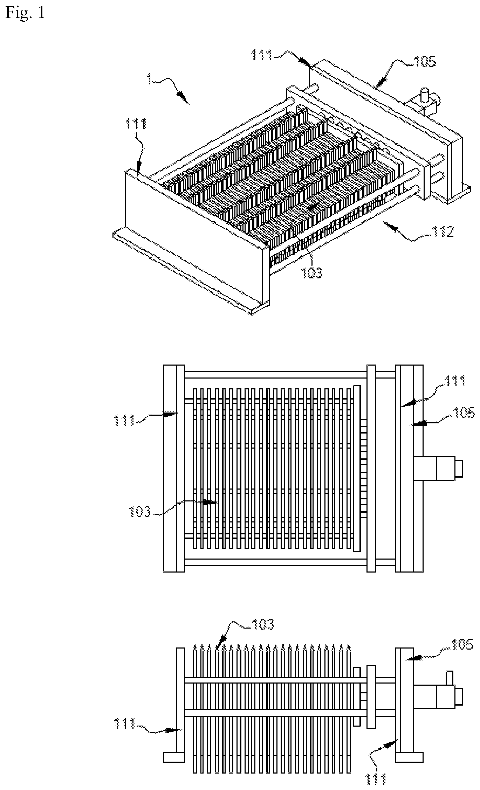

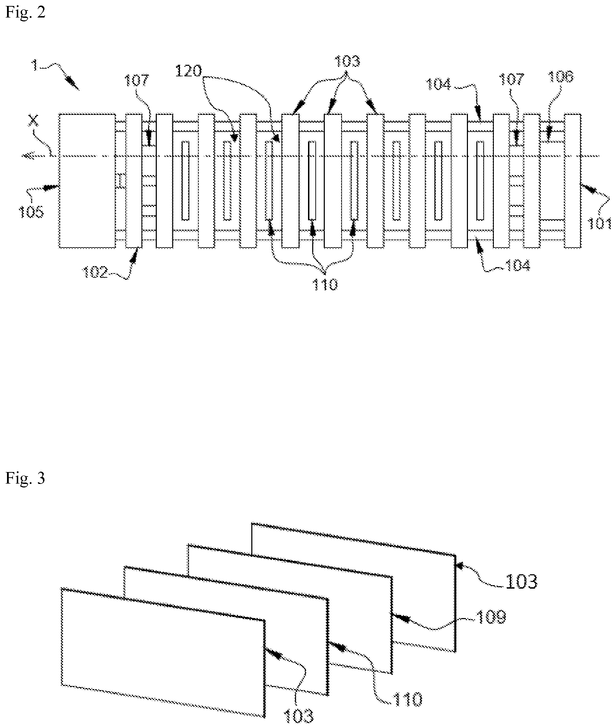

L'appareil d'inspection 1 est présenté sur la Figure 1 et la Figure 2 et comprend un élément de support 101 fixe.

L'élément de support 101 peut être installé de manière à être perpendiculaire à un cadre destiné à être installé sur un support, et le cadre peut comprendre un châssis 112 reposant sur le sol et une paire de cadres de support 111 prévus de part et d'autre du châssis 112 pour se faire face l'un l'autre.

L'appareil d'inspection 1 comprend également un élément mobile 102 installé pour faire face à l'élément de support 101 et qui est mobile par rapport à l'élément de support 101 le long d'un axe principal X dans une première direction vers l'élément de support 101 et une seconde direction opposée à la première direction, chaque direction étant le long de l'axe principal X.

La première direction est définie comme la direction selon laquelle l'élément mobile 102 se rapproche de l'élément de support 101 et la seconde direction est définie comme la direction selon laquelle l'élément mobile 102 s'éloigne de l'élément de support 101.

L'appareil d'inspection comprend également des éléments de pression 103 installés entre l'élément de support 101 et l'élément mobile 102 et mobiles librement le long de l'axe principal X. Deux éléments de pression adjacents 103 définissent un espace 120 destiné à recevoir uniquement une cellule secondaire 110.

L'espace 120 est destiné à recevoir une seule cellule secondaire 110. En ne recevant qu'une seule cellule secondaire, il est possible d'effectuer des mesures précises sur la cellule 110.

Les éléments de pression 103 peuvent notamment être des panneaux de pression qui peuvent être installés en parallèle entre l'élément de support 101 et l'élément mobile 102.

L'appareil d'inspection 1 comprend également :
- un élément de guidage 104 configuré pour guider chaque élément de pression 103 pour qu'il se déplace le long de l'axe principal X librement dans la première direction et dans la seconde direction de manière à ajuster un espace séparant deux éléments de pression 103 adjacents ; et
- une unité d'entraînement 105 configurée pour fonctionner dans un premier état dans lequel l'unité d'entraînement 105 presse l'au moins une cellule secondaire 110 qui se trouve entre les éléments de pression 103 des deux côtés, et dans un second état dans lequel l'unité d'entraînement 105 libère l'au moins une cellule secondaire 110,
un changement de fonctionnement entre le premier état et le second état étant obtenu en déplaçant l'élément mobile 102 dans la première direction et dans la seconde direction ;
- une unité de mesure de pression configurée pour mesurer la pression appliquée par l'unité d'entraînement 105.

Avantageusement, l'élément de guidage 104 permet d'obtenir des plaques sensiblement parallèles, permettant d'obtenir des mesures de pression exploitables.

Selon un mode de réalisation, l'unité de mesure de pression comprend un capteur de pression 106 interposé entre un élément fixe fixé pour faire face à l'élément de support 101 et le cadre de support prévu sur un côté du châssis 112, et le capteur de pression 106 peut être configuré pour mesurer une pression lorsque les éléments de pression 103 mettent sous pression l'au moins une cellule secondaire 110 lorsque l'unité d'entraînement 105 est dans son premier état de fonctionnement.

Selon un mode de réalisation, l'unité de mesure de pression comprend un capteur de pression compris entre deux éléments de pression adjacents parmi les éléments de pression 103, et le capteur de pression 106 peut comprendre une cellule de charge, une jauge de contrainte, une résistance sensible à la force ou une combinaison de tous les capteurs de pression cités.

L'appareil d'inspection 1 peut en outre comprendre une unité de support élastique configurée pour supporter de manière élastique l'élément de support 101 pour être ramené du côté de l'élément de pression, dans lequel l'unité de support élastique peut comprendre un élément fixe fixé pour faire face à l'élément de support 101 et un ressort de compression 107 introduit dans l'élément de guidage 104 de manière à être positionné entre l'élément fixe et l'élément de support 101.

L'appareil d'inspection est remarquable en ce que chaque élément de pression parmi les éléments de pression 103 comprend une plaque thermique 109 comme on peut le voir sur la Figure 3. La plaque thermique est configurée pour maintenir une température raisonnablement constante entre les éléments de pression 103. En d'autres termes, la plaque thermique est apte à maintenir une température constante entre les éléments de pression,

Les plaques thermiques permettent avantageusement d'obtenir une mesure de courant fiable et de bonne qualité. En effet ; la température du milieu environnant n'influent pas les mesure de courant. On peut donc s'affranchir d'une étape de correction des mesures de courant, cette étape de correction étant usuellement réalisée par calculs en tenant compte d'une valeur de température.

Les plaques thermiques se présentent sous la forme d'une platine métallique dans laquelle, s'étend un réseau d'éléments thermo régulateurs. Ces éléments thermo régulateurs peuvent être du type électrique ou encore du type à fluide caloporteur.

Par « raisonnablement constante », on entend que la température a une valeur constante de plus ou moins 1°C.

Les dimensions de chaque plaque thermique 109 peuvent être au moins égales aux dimensions de la cellule secondaire ou supérieures.

Les plaques thermiques 109 peuvent être couplées à un régulateur de température qui contrôle une valeur de la température entre deux éléments de pression adjacents 103.

Le régulateur de température peut permettre de régler une valeur de température avec une précision inférieure ou égale à 0,1°C.

Les plaques thermiques 109 ont une plage de température de fonctionnement comprise entre 5°C et 120°C. En pratique, l'utilisateur peut choisir la valeur de température raisonnablement constante dans une plage de température comprise entre 5°C et 120°C, avec une précision de plus ou moins 0,1°C. Une température de fonctionnement comprise dans cette plage de température permet d'obtenir des mesures de courant fiables tout en garantissant l'intégrité physique et chimique des cellules.

Avantageusement, cette plage de température de fonctionnement est adaptée aux conditions de fonctionnement de l'appareil d'inspection 1.

Les éléments de pression 103 peuvent chacun comprendre un tampon de pression fixé à un côté ou aux deux côtés de chaque élément de pression 103 afin de mettre sous pression efficacement l'au moins une cellule secondaire 110, et le tampon de pression peut comprendre un tampon en silicone et un papier isolant.

Le tampon en silicone est destiné à éviter l'endommagement de la cellule et le papier isolant est destiné à éviter les courts-circuits.

L'appareil d'inspection 1 comprend en outre une unité de contrôle de courant configurée pour appliquer une tension sur l'au moins une cellule secondaire 110 et pour mesurer un courant correspondant à travers l'au moins une cellule secondaire 110.

L'unité de contrôle de courant peut comprendre :
- une source d'énergie pour appliquer une tension pour atteindre une valeur de tension prédéterminée par rapport à l'au moins une cellule secondaire 110 mise sous pression par les éléments de pression 103 ; et
- une unité de mesure de courant pour mesurer une valeur de courant circulant à travers l'au moins une cellule secondaire 110.

Avantageusement, l'unité de contrôle de courant effectue un contrôle du courant de l'au moins une cellule secondaire 110 mise sous pression, ce qui permet de mesurer le courant circulant à travers l'au moins une cellule secondaire 110.

L'unité de contrôle de courant applique une tension prédéterminée à l'au moins une cellule secondaire 110, et mesure le courant de l'au moins une cellule secondaire 110.

L'appareil d'inspection 1 peut en outre comprendre un module d'électrode connecté à chacune des bornes d'électrode de l'au moins une cellule secondaire 110 pour ainsi appliquer ou recevoir du courant.

L'appareil d'inspection 1 peut comprendre en outre un contrôleur qui est connecté à l'unité d'entraînement 105, au module d'électrode et à l'unité de contrôle de courant, respectivement, pour commander les opérations de mise sous pression et de relâchement de l'unité d'entraînement 105, et pour déterminer s'il y a ou non un défaut dans l'au moins une cellule secondaire 110 en comparant la valeur de courant mesurée donnée par l'unité de contrôle de courant et une valeur de courant de référence.

Le contrôleur peut déterminer s'il y a un défaut en comparant une valeur moyenne des valeurs de courant mesurées par l'unité de contrôle de courant avec la valeur de référence pendant une période de temps prédéterminée qui peut dépendre des paramètres contrôlés par l'utilisateur de l'appareil d'inspection.

La période de temps prédéterminée peut être de 1 à 30 secondes.

La valeur de courant de référence peut être déterminée à partir d'une expérience, par exemple en se référant à une courbe d'étalonnage ou à un abaque qui montre si l'au moins une cellule secondaire 110 est défectueuse ou non en fonction de la valeur de courant mesurée.

L'appareil d'inspection 1 peut permettre l'inspection de nombreuses cellules secondaires 110 simultanément.

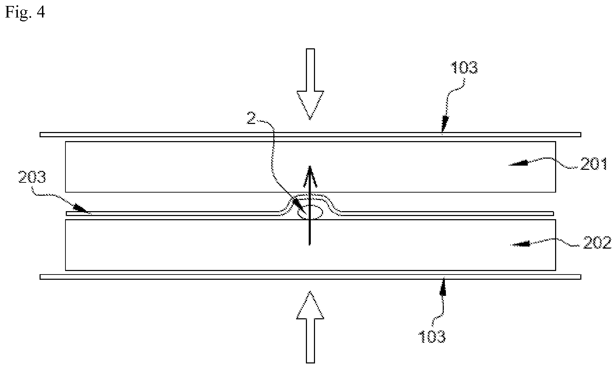

L'appareil d'inspection 1 est destiné à mettre sous pression l'au moins une cellule secondaire 110 pour permettre ou améliorer un contact physique entre la première électrode 201 et la seconde électrode 202 à travers le contaminant 2 afin d'induire un courant électrique qui circule à travers le contaminant 2 entre la première électrode 201 et la seconde électrode 202. Comme on peut le voir sur la Figure 4, la pression appliquée sur l'au moins une cellule secondaire 110 améliore la détection d'un contaminant potentiel 2 à l'intérieur de l'au moins une cellule secondaire 110 ; le courant circulant à travers le contaminant 2 est donc plus facile à détecter.

La première électrode 201 peut être une cathode et la seconde électrode 202 peut être une anode ou vice versa.

Le fonctionnement de l'appareil d'inspection 1 va maintenant être décrit.

Lorsque l'au moins une cellule secondaire 110 est introduite dans l'appareil d'inspection 1, l'élément mobile 102, installé pour faire face à l'élément de support 101, se déplace dans la première direction et dans la seconde direction le long de l'axe principal X par l'unité d'entraînement 105 pour mettre sous pression et dépressuriser les éléments de pression 103.

L'élément mobile 102 se déplace dans la première direction le long de l'axe principal X afin de mettre sous pression l'au moins une cellule secondaire 110. Un potentiel prédéterminé est appliqué à la cellule et le courant dans l'au moins une cellule secondaire 110 est alors mesuré et l'élément mobile 102 se déplace dans la deuxième direction le long de l'axe principal X après la mesure du courant afin de libérer l'au moins une cellule secondaire 110.

L'élément mobile 102 est mobile en translation selon la première direction et la deuxième direction, entre une première position et une deuxième position. La première position correspond au premier état dans lequel les cellules sont pressées par l'unité d'entraînement 105, et la deuxième position correspond au deuxième état dans lequel les cellules sont libérées par l'unité d'entraînement 105.

Les éléments de pression 103 mettent sous pression la partie de corps de l'au moins une cellule secondaire 110. Ici, la partie de corps fait référence à la partie de corps de l'au moins une cellule secondaire 110, à l'exception de la borne d'électrode de l'au moins une cellule secondaire 110.

Lorsque les éléments de pression 103 mettent sous pression l'au moins une cellule secondaire 110, l'unité de mesure de pression peut être interposée entre l'élément fixe et le cadre de support pour mesurer la pression.

Si la pression appliquée sur l'au moins une cellule secondaire 110 est trop élevée, l'électrode peut être détachée ou l'apparence de l'au moins une cellule secondaire 110 peut être endommagée. Au contraire, si la pression est trop faible, la première électrode 201 et la seconde électrode 202 peuvent ne pas être physiquement en contact l'une avec l'autre à travers le contaminant 2, de sorte qu'un court-circuit interne peut ne pas être déclenché, ce qui diminue la fiabilité de la détection des défauts. Ainsi, en détectant la pression appliquée sur l'au moins une cellule secondaire 110 par l'intermédiaire du capteur de pression 106, il est possible de vérifier si un niveau approprié de pression est appliqué.

Une tension est ensuite appliquée par l'unité de contrôle de courant afin d'effectuer un contrôle du courant de l'au moins une cellule secondaire 110 sous pression. À cette fin, la source d'énergie comprise dans l'unité de contrôle de courant applique une tension à travers le module d'électrode afin d'atteindre une valeur de tension prédéterminée, et l'unité de mesure de courant mesure la valeur du courant circulant à travers l'au moins une cellule secondaire 110.

L'unité de contrôle de courant et le module d'électrode peuvent être reliés électriquement par un câble, ou tout autre moyen de connexion électrique.

Le module d'électrode relie électriquement l'unité de contrôle de courant à l'au moins une cellule secondaire 110. Le module d'électrode peut être fixé à l'appareil d'inspection 1. Le module d'électrode est connecté à chacune des bornes d'électrode de l'au moins une cellule secondaire 110 et applique le courant appliqué par l'unité de contrôle de courant à l'au moins une cellule secondaire 110, ou transfère le courant de l'au moins une cellule secondaire 110 à l'unité de contrôle de courant.

Comme le courant mesuré est sensible aux variations de température, les plaques thermiques 109 agissent pour maintenir une température raisonnablement constante entre les éléments de pression 103. Cela permet de mesurer plus précisément la valeur du courant et d'éviter les erreurs de tri.

Ensuite, le contrôleur qui est connecté à l'unité d'entraînement 105, au module d'électrode et à l'unité de contrôle de courant, compare la valeur de courant mesurée par l'unité de contrôle de courant et la valeur de courant de référence afin de déterminer s'il y a ou non un défaut. En outre, le contrôleur peut comparer la valeur de courant de l'au moins une cellule secondaire 110 mesurée par l'unité de contrôle de courant avec une valeur de référence prédéterminée d'un bon produit et détermine si la valeur est acceptable selon les critères prédéterminés. Le résultat de la détermination peut être affiché par une unité d'affichage non représentée.

Le contrôleur détermine donc si l'au moins une cellule secondaire 110 est bonne ou non selon que la valeur mesurée en fonction de la quantité d'électricité mesurée ou du degré d'isolation correspond à une norme prédéterminée et peut permettre à l'unité d'affichage ou à un dispositif de sortie de données d'afficher le résultat de la détermination pour au moins une cellule secondaire 110.
Ces valeurs pourront varier en fonction d'un retour d'expérience et de la collecte de données, après production et inspection d'un certain nombre de cellules secondaires.

L'invention concerne également un procédé d'inspection pour inspecter au moins une cellule secondaire 110.

Le procédé d'inspection comprend une étape consistant à fournir un appareil d'inspection 1 tel que décrit précédemment et une étape consistant à fournir l'au moins une cellule secondaire 110 à inspecter.

Afin de fournir l'au moins une cellule secondaire 110 à inspecter, les sous-étapes suivantes peuvent être exécutées :
- assembler au moins la première électrode 201 et la seconde électrode 202 et un séparateur 203 interposé entre la première électrode 201 et la seconde électrode 202 afin de créer un bobinot ou un empilement ;
- placer le bobinot ou l'empilement dans un boîtier ou un sachet souple ;
- remplir le boîtier ou le sachet d'un électrolyte ;
- fermer hermétiquement le boîtier ou le sachet afin d'obtenir l'au moins une cellule secondaire 110 ;
- charger l'au moins une cellule secondaire 110 à un état de charge prédéterminé afin de former une interphase d'électrolyte solide sur la surface de la première électrode 201 avant de placer l'au moins une cellule secondaire 110 dans l'appareil d'inspection.

Selon une possibilité, un bobinot ou un empilement peut être créé en assemblant de nombreuses premières électrodes, de nombreuses secondes électrodes, de nombreux séparateurs et d'autres couches supplémentaires.

Ensuite, une fois que l'appareil d'inspection 1 et l'au moins une cellule secondaire 110 à inspecter sont fournis, les étapes suivantes sont exécutées :
- introduire l'au moins une cellule secondaire 110 dans l'appareil d'inspection 1 de telle sorte que l'au moins une cellule secondaire 110 soit introduite entre deux éléments de pression adjacents 103 ;
- mettre sous pression et libérer l'au moins une cellule secondaire 110 entre les éléments de pression 103 des deux côtés en déplaçant l'élément mobile 102 par rapport à l'élément de support 101 le long d'un axe principal X dans la première direction et la deuxième direction opposées l'une à l'autre le long de l'axe principal X ;
- maintenir une température raisonnablement constante entre les éléments de pression 103 en utilisant les plaques thermiques 109 comprises dans les éléments de pression 103 ;
- mesurer la pression appliquée à l'au moins une cellule secondaire 110 en utilisant l'unité de mesure de pression afin de déterminer si la pression appliquée est dans une plage de pression prédéfinie qui peut être comprise entre 200 et 5000 kgf/cm² ;
- appliquer une tension à l'au moins une cellule secondaire 110 et mesurer un courant correspondant à travers l'au moins une cellule secondaire 110.

Ensuite, afin de trier l'au moins une cellule secondaire 110 comme étant fonctionnelle ou défectueuse, les étapes suivantes peuvent être exécutées :
- comparer la valeur de courant mesurée à la valeur de courant de référence qui peut être définie à partir d'une expérience ;
- trier l'au moins une cellule secondaire 110 comme étant fonctionnelle ou défectueuse sur la base de la comparaison entre la valeur de courant mesurée et la valeur de courant de référence de telle sorte que :
   si la valeur de courant mesurée dépasse la valeur de courant de référence, l'au moins une cellule secondaire 110 est considérée comme défectueuse,
   si la valeur de courant mesurée est inférieure à la valeur de courant de référence, l'au moins une cellule secondaire 110 est considérée comme fonctionnelle.

Le capteur de pression permet de vérifier si la valeur de la pression appliquée est appropriée ou non.

Avantageusement, le procédé d'inspection décrit permet de maintenir une température raisonnablement constante à l'intérieur de l'appareil d'inspection 1 grâce à l'utilisation de plaques thermiques 109 comprises dans les éléments de pression 103.

Le courant mesuré circulant à travers la cellule secondaire dépend de la température et sera donc mesuré de manière plus précise en utilisant le procédé d'inspection décrit.

Le procédé d'inspection décrit permet un tri plus précis de l'au moins une cellule secondaire 110 inspectée.

Avantageusement, le procédé d'inspection peut être appliqué pendant un processus de fabrication de l'au moins une cellule secondaire 110 après une phase d'imprégnation de l'électrolyte, et avant une première charge de l'au moins une cellule secondaire 110.

Avantageusement, le procédé d'inspection peut être appliqué après la formation de la cellule.

Le procédé et l'appareil d'inspection décrits précédemment ont une application industrielle dans le domaine de la fabrication de cellules secondaires.

Ce qui s'applique dans cette description détaillée au procédé d'inspection s'applique également à l'appareil d'inspection, et vice versa.

## Revendications

1. Appareil d'inspection (1) pour inspecter au moins une cellule secondaire (110), l'appareil d'inspection (1) comprenant :
- un élément de support (101) fixe ;
- un élément mobile (102) installé pour faire face à l'élément de support (101) et étant mobile par rapport à l'élément de support (101) le long d'un axe principal (X) dans une première direction vers l'élément de support (101) et une seconde direction opposée à la première direction, chaque direction étant le long de l'axe principal (X) ;
- des éléments de pression (103) installés entre l'élément de support (101) et l'élément mobile (102), lesdits éléments de pression (103) étant librement mobiles le long de l'axe principal (X), deux éléments de pression adjacents (103) définissant un espace (120) destiné à recevoir une cellule secondaire (110) ;
et
- une unité d'entraînement (105) configurée pour fonctionner dans :
un premier état dans lequel l'unité d'entraînement (105) presse l'au moins une cellule secondaire (110) qui se trouve entre les éléments de pression (103) des deux côtés, et
un second état dans lequel l'unité d'entraînement (105) libère l'au moins une cellule secondaire (110),
- une unité de mesure de pression configurée pour mesurer la pression appliquée par l'unité d'entraînement (105) ;
- une unité de contrôle de courant configurée pour appliquer une tension sur l'au moins une cellule secondaire (110) et pour mesurer un courant correspondant à travers l'au moins une cellule secondaire (110) ;
dans lequel :
chaque élément de pression parmi les éléments de pression (103) comprend une plaque thermique (109) comprenant une platine métallique comprenant un réseau d'éléments thermo régulateurs, la plaque thermique (109) étant apte à maintenir une température constante entre les éléments de pression (103) dans une plage de température comprise entre 5°C et 120°C.

2. Appareil d'inspection (1) selon la revendication 1, comprenant en outre :
- un élément de guidage (104) configuré pour guider chaque élément de pression (103) pour qu'il se déplace le long de l'axe principal (X) librement dans la première direction et dans la seconde direction de manière à ajuster l'espace (120) séparant deux éléments de pression adjacents (103).

3. Appareil d'inspection (1) selon l'une quelconque des revendications 1 ou 2, dans lequel les plaques thermiques (109) sont couplées à un régulateur de température qui contrôle une valeur de la température entre deux éléments de pression adjacents.

4. Appareil d'inspection (1) selon l'une quelconque des revendications 1 à 3, dans lequel l'unité de contrôle de courant comprend :
- une source d'énergie pour appliquer une tension pour atteindre une valeur de tension prédéterminée par rapport à l'au moins une cellule secondaire (110) mise sous pression par les éléments de pression (103 ); et
- une unité de mesure de courant pour mesurer une valeur de courant circulant à travers l'au moins une cellule secondaire (110).

5. Appareil d'inspection (1) selon l'une quelconque des revendications 1 à 4, comprenant en outre un module d'électrode connecté à chacune des bornes d'électrode de l'au moins une cellule secondaire (110) pour ainsi appliquer ou recevoir du courant.

6. Appareil d'inspection (1) selon les revendications 4 et 5, comprenant en outre un contrôleur qui est connecté à l'unité d'entraînement (105), au module d'électrode et à l'unité de contrôle de courant, respectivement, pour commander les opérations de mise sous pression et de relâchement de l'unité d'entraînement (105), et pour déterminer s'il y a ou non un défaut dans l'au moins une cellule secondaire (110) en comparant la valeur de courant mesurée donnée par l'unité de contrôle de courant et une valeur de courant de référence.

7. Appareil d'inspection (1) selon l'une quelconque des revendications 1 à 6, comprenant un cadre destiné à être installé sur un support, l'élément de support (101) étant installé de manière à être perpendiculaire au cadre,
le cadre comprenant un châssis (112) reposant sur le sol et une paire de cadres de support (111) prévus de part et d'autre du châssis (112) pour se faire face,
et dans lequel :
l'unité de mesure de pression comprend un capteur de pression (106) interposé entre un élément fixe fixé pour faire face à l'élément de support (101) et le cadre de support prévu sur un côté du châssis (112),
le capteur de pression (106) étant configuré pour mesurer une pression lorsque les éléments de pression (103) mettent sous pression l'au moins une cellule secondaire (110) lorsque l'unité d'entraînement (105) est dans son premier état de fonctionnement.

8. Appareil d'inspection (1) selon l'une quelconque des revendications 1 à 7, dans lequel l'unité de mesure de pression comprend un capteur de pression compris entre deux éléments de pression adjacents parmi les éléments de pression.

9. Appareil d'inspection (1) selon l'une quelconque des revendications 1 à 8, dans lequel l'espace (120) est destiné à recevoir une seule cellule secondaire (110).

10. Appareil d'inspection (1) selon l'une quelconque des revendications 1 à 9, dans lequel l'élément mobile (102) est mobile en translation selon la première direction et la deuxième direction, entre une première position correspondant au premier état et une deuxième position correspondant au deuxième état.

11. Procédé d'inspection pour inspecter au moins une cellule secondaire(110), le procédé d'inspection comprenant les étapes suivantes :
- fournir un appareil d'inspection (1) selon l'une quelconque des revendications 1 à 10 ;
- fournir l'au moins une cellule secondaire (110) à inspecter ;
- introduire l'au moins une cellule secondaire (110) dans l'appareil d'inspection (1) de sorte que l'au moins une cellule secondaire (110) soit introduite entre deux éléments de pression adjacents (103) ;
- mettre sous pression et libérer l'au moins une cellule secondaire (110) entre les éléments de pression (103) des deux côtés en déplaçant l'élément mobile (102) par rapport à l'élément de support (101) le long d'un axe principal (X) dans une première direction et une seconde direction opposées l'une à l'autre le long de l'axe principal (X) ;
- maintenir une température constante entre les éléments de pression (103) en utilisant les plaques thermiques (109) comprises dans les éléments de pression (103) ;
- mesurer la pression appliquée à l'au moins une cellule secondaire (110) en utilisant l'unité de mesure de pression afin de déterminer si la pression appliquée est dans une plage de pression prédéfinie ;
- appliquer une tension à l'au moins une cellule secondaire (110) et mesurer un courant correspondant à travers l'au moins une cellule secondaire (110).

12. Procédé d'inspection selon la revendication 11 comprenant en outre les étapes suivantes :
- comparer la valeur de courant mesurée à une valeur de courant de référence ;
- trier l'au moins une cellule secondaire (110) comme étant fonctionnelle ou défectueuse sur la base de la comparaison entre la valeur de courant mesurée et la valeur de courant de référence de telle sorte que :
si la valeur de courant mesurée dépasse la valeur de courant de référence, l'au moins une cellule secondaire (110) est considérée comme défectueuse,
si la valeur de courant mesurée est inférieure à la valeur de courant de référence, l'au moins une cellule secondaire (110) est considérée comme fonctionnelle.

13. Procédé d'inspection selon les revendications 11 et 12, dans lequel l'étape consistant à fournir l'au moins une cellule secondaire (110) comprend les sous-étapes suivantes :
- assembler une première électrode (201) et une seconde électrode (202) et un séparateur (203) interposé entre la première électrode (201) et la seconde électrode (202) afin de créer un bobinot ou un empilement ;
- placer le bobinot ou l'empilement dans un boîtier ou un sachet souple ;
- remplir le boîtier ou le sachet d'un électrolyte ;
- fermer hermétiquement le boîtier ou le sachet afin d'obtenir l'au moins une cellule secondaire (110) ;
- charger l'au moins une cellule secondaire (110) à un état de charge prédéterminé afin de former une interphase d'électrolyte solide sur la surface de la première électrode (201) avant de placer l'au moins une cellule secondaire (110) dans l'appareil d'inspection.

## Patentansprüche

1. Prüfvorrichtung (1) zum Prüfen mindestens einer Sekundärzelle (110), die Prüfvorrichtung (1) umfassend:
- ein ortsfestes Trägerelement (101);
- ein bewegliches Element (102), das so installiert ist, dass es dem Trägerelement (101) gegenüberliegt und relativ zu dem Trägerelement (101) entlang einer Hauptachse (X) in einer ersten Richtung zum Trägerelement (101) hin und einer zur ersten Richtung entgegengesetzten zweiten Richtung beweglich ist, wobei jede Richtung entlang der Hauptachse (X) verläuft;
- Druckelemente (103), die zwischen dem Trägerelement (101) und dem beweglichen Element (102) installiert sind, wobei die Druckelemente (103) entlang der Hauptachse (X) frei beweglich sind und zwei benachbarte Druckelemente (103) einen Raum (120) definieren, der zur Aufnahme einer Sekundärzelle (110) bestimmt ist;
und
- eine Antriebseinheit (105), die konfiguriert ist für den Betrieb:
in einem ersten Zustand, in dem die Antriebseinheit (105) die mindestens eine Sekundärzelle (110), die sich zwischen den Druckelementen (103) befindet, beidseitig mit Druck beaufschlagt, und
in einem zweiten Zustand, in dem die Antriebseinheit (105) die mindestens eine Sekundärzelle (110) freigibt,
- eine Druckmesseinheit, die dazu konfiguriert ist, den von der Antriebseinheit (105) ausgeübten Druck zu messen;
- eine Stromsteuereinheit, die dazu konfiguriert ist, eine Spannung an die mindestens eine Sekundärzelle (110) anzulegen und einen entsprechenden Strom durch die mindestens eine Sekundärzelle (110) zu messen;
wobei:
jedes Druckelement von den Druckelementen (103) eine Thermoplatte (109) umfasst, die eine Metallplatine mit einem Netzwerk aus Wärmeregelungselementen umfasst, wobei die Thermoplatte (109) dazu geeignet ist, eine konstante Temperatur zwischen den Druckelementen (103) in einem Temperaturbereich zwischen 5 °C und 120 °C aufrechtzuerhalten.

2. Prüfvorrichtung (1) nach Anspruch 1, ferner umfassend:
- ein Führungselement (104), das dazu konfiguriert ist, jedes Druckelement (103) so zu führen, dass es sich entlang der Hauptachse (X) in der ersten Richtung und in der zweiten Richtung derart frei bewegen kann, dass der Raum (120) angepasst wird, der zwei benachbarte Druckelemente (103) voneinander trennt.

3. Prüfvorrichtung (1) nach einem der Ansprüche 1 oder 2, wobei die Thermoplatten (109) mit einem Temperaturregler gekoppelt sind, der einen Temperaturwert zwischen zwei benachbarten Druckelementen regelt.

4. Prüfvorrichtung (1) nach einem der Ansprüche 1 bis 3, wobei die Stromsteuereinheit umfasst:
- eine Energiequelle zum Anlegen einer Spannung zum Erreichen eines vorgegebenen Spannungswerts relativ zu der mindestens einen durch die Druckelemente (103) mit Druck beaufschlagten Sekundärzelle (110); und
- eine Strommesseinheit zum Messen eines durch die mindestens eine Sekundärzelle (110) fließenden Stromwerts.

5. Prüfvorrichtung (1) nach einem der Ansprüche 1 bis 4, die ferner ein Elektrodenmodul umfasst, das mit jedem der Elektrodenanschlüsse der mindestens einen Sekundärzelle (110) verbunden ist, um somit Strom anzulegen oder zu empfangen.

6. Prüfvorrichtung (1) nach den Ansprüchen 4 und 5, die ferner eine Steuerung umfasst, die mit der Antriebseinheit (105), dem Elektrodenmodul bzw. der Stromsteuereinheit verbunden ist, um die Druckbeaufschlagungs- und Entlastungsvorgänge der Antriebseinheit (105) zu steuern und um durch Vergleichen des von der Stromsteuereinheit ausgegebenen gemessenen Stromwerts mit einem Referenzstromwert zu bestimmen, ob in der mindestens einen Sekundärzelle (110) ein Defekt vorliegt oder nicht.

7. Prüfvorrichtung (1) nach einem der Ansprüche 1 bis 6, die einen Rahmen umfasst, der dazu bestimmt ist, an einen Träger montiert zu werden, wobei das Trägerelement (101) so installiert ist, dass es senkrecht zum Rahmen steht,
wobei der Rahmen ein auf dem Boden ruhendes Chassis (112) und ein Paar Stützrahmen (111) umfasst, die auf beiden Seiten des Chassis (112) einander zugewandt vorgesehen sind,
und wobei:
die Druckmesseinheit einen Drucksensor (106) umfasst, der zwischen einem ortsfesten Element, das dem Trägerelement (101) zugewandt befestigt ist, und dem Trägerrahmen, der auf einer Seite des Chassis (112) vorgesehen ist, angeordnet ist,
wobei der Drucksensor (106) dazu konfiguriert ist, einen Druck zu messen, wenn die Druckelemente (103) die mindestens eine Sekundärzelle (110) mit Druck beaufschlagen, wenn sich die Antriebseinheit (105) in ihrem ersten Betriebszustand befindet.

8. Prüfvorrichtung (1) nach einem der Ansprüche 1 bis 7, wobei die Druckmesseinheit einen Drucksensor umfasst, der zwischen zwei innerhalb der Druckelemente benachbarten Druckelementen angeordnet ist.

9. Prüfvorrichtung (1) nach einem der Ansprüche 1 bis 8, wobei der Raum (120) zur Aufnahme einer einzelnen Sekundärzelle (110) bestimmt ist.

10. Prüfvorrichtung (1) nach einem der Ansprüche 1 bis 9, wobei das bewegliche Element (102) in der ersten Richtung und der zweiten Richtung translatorisch zwischen einer ersten Position, die dem ersten Zustand entspricht, und einer zweiten Position, die dem zweiten Zustand entspricht, beweglich ist.

11. Prüfverfahren zum Prüfen mindestens einer Sekundärzelle (110), das Prüfverfahren die folgenden Schritte umfassend:
- Bereitstellen einer Prüfvorrichtung (1) nach einem der Ansprüche 1 bis 10;
- Bereitstellen mindestens einer zu prüfenden Sekundärzelle (110);
- Einsetzen der mindestens einen Sekundärzelle (110) in die Prüfvorrichtung (1), sodass die mindestens eine Sekundärzelle (110) zwischen zwei benachbarten Druckelementen (103) eingesetzt wird;
- Druckbeaufschlagen und Freigeben der mindestens einen Sekundärzelle (110) zwischen den Druckelementen (103) auf beiden Seiten durch Bewegen des beweglichen Elements (102) relativ zum Trägerelement (101) entlang einer Hauptachse (X) in einer ersten Richtung und einer zweiten Richtung, die entlang der Hauptachse (X) einander entgegengesetzt sind;
- Aufrechterhalten einer konstanten Temperatur zwischen den Druckelementen (103) durch Verwendung der in den Druckelementen (103) enthaltenen Thermoplatten (109);
- Messen des auf die mindestens eine Sekundärzelle (110) ausgeübten Drucks mittels der Druckmesseinheit, um zu bestimmen, ob der ausgeübte Druck innerhalb eines vordefinierten Druckbereichs liegt;
- Anlegen einer Spannung an die mindestens eine Sekundärzelle (110) und Messen eines entsprechenden Stroms durch die mindestens eine Sekundärzelle (110).

12. Prüfverfahren nach Anspruch 11, ferner die folgenden Schritte umfassend:
- Vergleichen des gemessenen Stromwerts mit einem Referenzstromwert;
- Einsortieren der mindestens einen Sekundärzelle (110) als funktionsfähig oder defekt basierend auf dem Vergleich zwischen dem gemessenen Stromwert und dem Referenzstromwert, so dass:
wenn der gemessene Stromwert den Referenzstromwert überschreitet, die mindestens eine Sekundärzelle (110) als defekt betrachtet wird,
wenn der gemessene Stromwert kleiner als der Referenzstromwert ist, die mindestens eine Sekundärzelle (110) als funktionsfähig betrachtet wird.

13. Prüfverfahren nach den Ansprüchen 11 und 12, wobei der Schritt des Bereitstellens der mindestens einen Sekundärzelle (110) die folgenden Teilschritte umfasst:
- Zusammenbauen einer ersten Elektrode (201) und einer zweiten Elektrode (202) und eines zwischen der ersten Elektrode (201) und der zweiten Elektrode (202) angeordneten Separators (203), um eine Spule oder einen Stapel zu erzeugen;
- Platzieren der Spule oder des Stapels in einem Gehäuse oder einem flexiblen Beutel;
- Füllen des Gehäuses oder des Beutels mit einem Elektrolyten;
- hermetisches Versiegeln des Gehäuses oder des Beutels, sodass mindestens eine Sekundärzelle (110) erhalten wird;
- Aufladen der mindestens einen Sekundärzelle (110) auf einen vorgegebenen Ladezustand, um eine Festelektrolyt-Grenzfläche auf der Oberfläche der ersten Elektrode (201) zu bilden, bevor die mindestens eine Sekundärzelle (110) in die Prüfvorrichtung eingesetzt wird.

## Claims

1. Inspection apparatus (1) for inspecting at least one secondary cell (110), the inspection apparatus (1) comprising:
- a fixed support element (101);
- a movable element (102) installed to face the support element (101) and being movable with respect to the support element (101) along a main axis (X) in a first direction towards the support element (101) and a second direction opposite to the first direction, each direction being along the main axis (X);
- pressure elements (103) installed between the support element (101) and the movable element (102), said pressure elements (103) being freely movable along the main axis (X), two adjacent pressure elements (103) defining a space (120) designed for receiving a secondary cell (110);
and
- a drive unit (105) designed to operate in:
a first state in which the drive unit (105) presses the at least one secondary cell (110) located between the pressure elements (103) on both sides, and
a second state in which the drive unit (105) releases the at least one secondary cell (110),
- a pressure measurement unit designed to measure the pressure applied by the drive unit (105);
- a current control unit designed to apply a voltage to the at least one secondary cell (110) and to measure a corresponding current through the at least one secondary cell (110);
wherein:
each pressure element among the pressure elements (103) comprises a thermal plate (109) comprising a metal sheet having a network of thermoregulatory elements, the thermal plate (109) being suitable for maintaining a constant temperature between the pressure elements (103) within a temperature range of between 5°C and 120°C.

2. Inspection apparatus (1) according to claim 1, further comprising:
- a guide element (104) designed to guide each pressure element (103) so that it moves along the main axis (X) freely in the first direction and in the second direction so as to adjust the space (120) separating two adjacent pressure elements (103).

3. Inspection apparatus (1) according to either claim 1 or claim 2, wherein the thermal plates (109) are coupled to a temperature regulator which controls a temperature value between two adjacent pressure elements.

4. Inspection apparatus (1) according to any of claims 1 to 3, wherein the current control unit comprises:
- a power source for applying a voltage in order to reach a predetermined voltage value with respect to the at least one secondary cell (110) pressurized by the pressure elements (103); and
- a current measurement unit for measuring a current value flowing through the at least one secondary cell (110).

5. Inspection apparatus (1) according to any of claims 1 to 4, further comprising an electrode module connected to each of the electrode terminals of the at least one secondary cell (110) to thereby apply or receive current.

6. Inspection apparatus (1) according to claims 4 and 5, further comprising a controller which is connected to the drive unit (105), the electrode module and the current control unit, respectively, in order to control the pressurizing and release operations of the drive unit (105), and to determine whether or not there is a fault in the at least one secondary cell (110) by comparing the measured current value given by the current control unit and a reference current value.

7. Inspection apparatus (1) according to any of claims 1 to 6, comprising a frame designed to be installed on a support, the support element (101) being installed so as to be perpendicular to the frame,
the frame comprising a chassis (112) resting on the ground and a pair of support frames (111) provided on either side of the chassis (112) to face each other,
and wherein:
the pressure measurement unit comprises a pressure sensor (106) positioned between a fixed element fixed to face the support element (101) and the support frame provided on one side of the chassis (112),
the pressure sensor (106) being designed to measure a pressure when the pressure elements (103) pressurize the at least one secondary cell (110) when the drive unit (105) is in the first operating state thereof.

8. Inspection apparatus (1) according to any of claims 1 to 7, wherein the pressure measurement unit comprises a pressure sensor between two adjacent pressure elements among the pressure elements.

9. Inspection apparatus (1) according to any of claims 1 to 8, wherein the space (120) is designed to accommodate a single secondary cell (110).

10. Inspection apparatus (1) according to any of claims 1 to 9, wherein the movable element (102) is translatably movable in the first direction and the second direction, between a first position corresponding to the first state and a second position corresponding to the second state.

11. Inspection method for inspecting at least one secondary cell (110), the inspection method comprising the following steps:
- providing an inspection apparatus (1) according to any of claims 1 to 10;
- providing the at least one secondary cell (110) to be inspected;
- inserting the at least one secondary cell (110) into the inspection apparatus (1) so that the at least one secondary cell (110) is inserted between two adjacent pressure elements (103);
- pressurizing and releasing the at least one secondary cell (110) between the pressure elements (103) on both sides by moving the movable element (102) with respect to the support element (101) along a main axis (X) in a first direction and a second direction opposite one another along the main axis (X);
- maintaining a constant temperature between the pressure elements (103) using the thermal plates (109) in the pressure elements (103);
- measuring the pressure applied to the at least one secondary cell (110) using the pressure measurement unit in order to determine whether the applied pressure is within a predefined pressure range;
- applying a voltage to the at least one secondary cell (110) and measuring a corresponding current through the at least one secondary cell (110).

12. Inspection method according to claim 11, further comprising the following steps:
- comparing the measured current value with a reference current value;
- sorting the at least one secondary cell (110) as being functional or faulty on the basis of the comparison between the measured current value and the reference current value so that:
if the measured current value exceeds the reference current value, the at least one secondary cell (110) is considered faulty,
if the measured current value is less than the reference current value, the at least one secondary cell (110) is considered functional.

13. Inspection method according to claims 11 and 12, wherein the step of providing the at least one secondary cell (110) comprises the following sub-steps:
- assembling a first electrode (201) and a second electrode (202) and a separator (203) positioned between the first electrode (201) and the second electrode (202) in order to create a coil or a stack;
- placing the coil or stack in a case or flexible pouch;
- filling the case or pouch with an electrolyte;
- hermetically sealing the case or pouch in order to obtain the at least one secondary cell (110);
- charging the at least one secondary cell (110) to a predetermined charge state in order to form a solid electrolyte interphase on the surface of the first electrode (201) before placing the at least one secondary cell (110) in the inspection apparatus.
